# EUROPÄISCHE PATENTSCHRIFT

(11) **EP 1 390 559 B1**
(45) Veröffentlichungstag und Bekanntmachung des Hinweises auf die Patenterteilung: **05.09.2007**
(21) Anmeldenummer: 01962685.2
(22) Anmeldetag: 22.05.2001
(51) Int. Cl.: C23C 14/58, C23C 16/56, H01C 17/24, H01J 37/305

(54) **VERFAHREN ZUR HERSTELLUNG EINER SCHICHT MIT EINEM VORDEFINIERTEN SCHICHTDICKENPROFIL**
METHOD FOR PRODUCING A LAYER WITH A PREDEFINED LAYER THICKNESS PROFILE
PROCEDE DE PRODUCTION D'UNE COUCHE PRESENTANT UN PROFIL D'EPAISSEUR DE COUCHE PREDEFINI

(43) Veröffentlichungstag der Anmeldung: 25.02.2004
(60) Teilanmeldung: 07008531.1
(73) Patentinhaber: Infineon Technologies AG, 81669 München (DE)
(72) Erfinder: AIGNER, Robert, 81675 München (DE); MARKSTEINER, Stephan, 85640 Putzbrunn (DE); NESSLER, Winfried, 81739 München (DE); ELBRECHT, Lüder, 81825 München (DE); TIMME, Hans-Jörg, 85521 Ottobrunn (DE)
(74) Vertreter: Ginzel, Christian
(86) Internationale Anmeldenummer: PCT/EP2001/005889
(87) Internationale Veröffentlichungsnummer: WO 2002/095085

(56) Entgegenhaltungen:
- US-A- 4 075 452
- US-A- 4 457 803
- US-A- 5 266 529
- PATENT ABSTRACTS OF JAPAN vol. 009, no. 169 (E-328), 13. Juli 1985 (1985-07-13) & JP 60 042832 A (MATSUSHITA DENKI SANGYO KK), 7. März 1985 (1985-03-07)
- PATENT ABSTRACTS OF JAPAN vol. 010, no. 332 (E-453), 12. November 1986 (1986-11-12) & JP 61 137327 A (NEC CORP), 25. Juni 1986 (1986-06-25)
- PATENT ABSTRACTS OF JAPAN vol. 016, no. 526 (E-1286), 28. Oktober 1992 (1992-10-28) & JP 04 196610 A (SEIKO EPSON CORP), 16. Juli 1992 (1992-07-16)
- PATENT ABSTRACTS OF JAPAN vol. 1995, no. 06, 31. Juli 1995 (1995-07-31) & JP 07 073834 A (NIPPON STEEL CORP), 17. März 1995 (1995-03-17)

## Beschreibung

Die Erfindung betrifft ein Verfahren zur Herstellung einer Schicht mit einem vorgegebenen bzw. angepaßten Schichtdickenprofil. Die Erfindung betrifft insbesondere ein Verfahren zur Herstellung einer Schicht mit einem vorgegebenen bzw. angepaßten Schichtdickenprofil zur Durchführung eines Frequenzabgleichs bei piezoelektrischen Schwingkreisen.

Die Eigenfrequenz von Schwingkreisen auf der Basis von piezoelektrischen Dünnfilmen im Frequenzbereich über 500 MHz ist indirekt proportional zur Schichtdicke der Piezoschicht. Der akustisch isolierende Unterbau sowie die Boden- und Deckelelektroden stellen eine zusätzliche Massenbelastung für den Schwingkreis dar, die eine Reduzierung der Eigenfrequenz bewirkt. Die Dickenschwankungen in allen diesen Schichten bestimmen den Bereich der Fertigungstoleranzen, in dem die Eigenfrequenz eines Exemplars des Schwingkreises liegt. Für Sputterprozesse in der Mikroelektronik sind Schichtdickenschwankungen von 5% typisch, mit einigem Aufwand können 1% (1σ) erreicht werden. Diese Schwankungen treten sowohl statistisch von Scheibe zu Scheibe als auch systematisch zwischen Scheibenmitte und Rand auf.

Die Dickentoleranzen der einzelnen Schichten im akustischen Pfad von Schwingkreisen auf der Basis von piezoelektrischen Dünnfilmen sind im wesentlichen stochastisch voneinander unabhängig. Die durch diese Dickentoleranzen verursachten Frequenzfehler bzw. -streuungen addieren sich daher nach dem Fehlerfortpflanzungsgesetz. Für Schwingkreise auf der Basis von piezoelektrischen Dünnfilmen ergibt sich dabei typisch eine Gesamtfrequenzstreuung von ca. 2% (1σ). Für Anwendungen im GHz-Bereich müssen jedoch die Eigenfrequenzen einzelner Schwingkreise zumindest eine absolute Genauigkeit von 0,5% aufweisen. In Hochpräzisionsanwendungen ergibt sich aus den Spezifikationen ein Toleranzfenster von nur 0.25%.

Für hochselektive Anwendungen müssen mehrere Schwingkreise in Leiter-, Gitter- oder Parallelkonfigurationen verschaltet werden. Die individuellen Schwingkreise müssen gezielt zueinander verstimmt werden, um die gewünschte Charakteristik zu erreichen. Vorzugsweise werden aus Kostengründen alle Schwingkreise eines Bauteils aus einer Piezoschicht konstanter Dicke hergestellt. Die Frequenzabstimmung erfolgt in der Regel durch additive Schichten in dem akustisch aktiven Stapel. Für jede vorkommende Eigenfrequenz muß eine Zusatzschicht unterschiedlicher Dicke hergestellt werden. Das erfordert in der Regel jeweils einen Abscheide- oder Ätzschritt, verbunden mit einem Lithografieschritt. Um diesen Aufwand zu begrenzen, werden üblicherweise nur Topologien hergestellt, mit denen nur zwei Eigenfrequenzen eingestellt werden.

In dem Dokument US 5,587,620 sind Verfahren beschrieben, bei denen durch eine Device-spezifische Abscheidung einer zusätzlichen Schicht ein Frequenzabgleich erreicht wird. Solche verfahren, die nicht auf Waferebene durchgeführt werden können, sind jedoch mit vergleichsweise hohen Fertigungskosten verbunden. Weiterhin wird in dem Dokument US 5,587,620 ein Frequenzabgleich über eine Temperaturveränderungen vorgeschlagen. In dem Dokument EP 0 771 070 A2 wird ein Frequenzabgleich durch das Hinzuschalten weiterer passiver Komponenten erreicht. Leider weisen derartige Verfahren in der Regel einen zu geringen Frequenzeffekt auf bzw. führen zu anderen unerwünschten Veränderungen der Charakteristik des Schwingkreises.

Die US 5,266,529 beschreibt ein Verfahren zur Herstellung eines Dünnfilm-Widerstands, bei dem auf ein isolierendes Substrat eine Schicht eines Widerstandsmaterials aufgebracht wird. An den seitlichen Enden der Widerstandsschicht werden Anschlußpads aufgebracht. Mit Hilfe eines Ionenstrahls werden dann ausgewählte Bereiche der Schicht entfernt, um eine Schnittfuge auszubilden. Durch diese Schnittfuge wird ein darunterliegender Bereich des Substrats freigelegt. Durch die Schnittfuge wird der für die Leitung zur Verfügung stehende Leitungspfad verringert, so daß eine Erhöhung des Widerstands der Schicht eintritt.

Die JP 61 137327 beschreibt ein Verfahren zur Ätzung von Isolationsschichten mit einem gewünschten Profil, bei dem die Tatsache ausgenutzt wird, daß ein Ionenstrahl typischerweise ein Gaußprofil aufweist. Durch eine geeignete Überlagerung von Gaußprofilen wird ein gewünschtes Abtragsprofil bei der Ätzung einer Isolationsschicht durch einen Ionenstrahl erzielt.

Die JP 07 073834 beschreibt ein Verfahren zur Herstellung von Dünnschichten, bei dem eine Röntgenquelle einen Röntgenstrahl aussendet, der ein Werkstück durchdringt und von einer Röntgenkamera erfaßt wird. Weiterhin ist eine Ionenquelle, die eine Ablenkeinrichtung aufweist, auf das Werkstück ausgerichtet. Mit Hilfe des Ionenstrahls wird das Werkstück geätzt und die jeweilige Ätzposition entweder durch Verschieben des Probentischs oder durch Ablenken des Ionenstrahls durch die Ablenkeinrichtung geändert.

Die EP 1 258 990 beschreibt ein Verfahren zum Einstellen der Frequenzen von akustischen Resonatoren und Filtern durch Einstellen der lokalen Schichtdicke. Dabei wird eine Karte der Schichtdickeninhomogenität anhand der gemessenen Frequenzen erstellt und anschließend eine Ätzung mit einem Ionenstrahl vorgenommen.

Aus EP 1 233 510 ist ebenfalls ein Verfahren zum Einstellen der Frequenzen von akustischen Resonatoren bekannt. Dazu wird zunächst das Schichtdickenprofil einer Schicht der akustischen Resonatoren bestimmt. Anschließend wird die Schicht lokal mit einem Ionenstrahl geätzt und überschüssiges Material von der Schicht entfernt. Zum Ätzen wird eine Ionenquelle verwendet, die einen lateral ausgedehnten Ionenstrahl erzeugt. Mittels einer zwischen der zu ätzenden Schicht und der Ionenquelle angeordneten Blende mit kleiner Öffnung wird lediglich ein geringer Teil des von der Ionenquelle emittierten Strahls durchgelassen und so ein homogener Ionenstrahl erzeugt. Durch laterales Bewegen der Blende wird die zu ätzende Schicht abgerastert.

Der vorliegenden Erfindung liegt daher die Aufgabe zugrunde, ein Verfahren zur Herstellung einer Schicht mit einem lokal angepaßtem bzw. vorgegebenen Schichtdickenprofil bereitzustellen, das die genannten Schwierigkeiten vermindert bzw. ganz vermeidet. Insbesondere liegt der vorliegenden Erfindung die Aufgabe zugrunde, ein Verfahren bereitzustellen, das zur Einstellung der Eigenfrequenzen von piezoelektrischen Schwingkreisen verwendet werden kann.

Diese Aufgabe wird von dem Verfahren zur Herstellung einer Schicht mit einem lokal angepaßtem bzw. vorgegebenen Schichtdickenprofil gemäß des unabhängigen Patentanspruchs 1 gelöst. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Herstellung einer Schicht mit einem lokal angepaßtem bzw. vorgegebenen Schichtdickenprofil bereitgestellt, das im Falle des Vertragsstaats NL die folgenden Schritte umfaßt:
a) zumindest eine Schicht wird auf ein Substrat aufgebracht,
b) ein Abtragsprofil wird für die aufgebrachten Schicht durch Vermessung der aufgebrachten Schicht bestimmt, und
c) zumindest ein Ionenstrahl wird zumindest einmal über die Schicht geführt, so daß am Ort des Ionenstrahls eine lokale Ätzung der Schicht entsprechend dem Abtragsprofil erfolgt und eine Schicht mit einem lokal angepaßtem bzw. vorgegebenen Schichtdickenprofil erzeugt wird.

Im Falle der Vertragsstaaten DE, FR, GB und IT ist das Verfahren nach Anspruch 1 noch zusätzlich charakterisiert dadurch, daß die Ausdehnung des lonenstrahls größer als 1 mm, bevorzugt größer als 5 mm ist und ein lonenstrahl mit einer gaussförmigen Stromdichteverteilung verwendet wird.

Das erfindungsgemäße Verfahren besitzt den Vorteil, daß sowohl zufällige Schwankungen von Wafer zu Wafer als auch systematische Schwankungen zwischen Wafermitte und Waferrand korrigiert werden können. Das erfindungsgemäße Verfahren erlaubt eine kosteneffiziente Korrektur dieser Schwankungen mit vergleichsweise einfachem Equipment. Darüber hinaus kann das erfindungsgemäße Verfahren dazu verwendet werden, Schichten mit gezielt unterschiedlich dicken Bereichen herzustellen. Das erfindungsgemäße Verfahren besitzt zusätzlich den Vorteil, daß es universell für beliebige Schichtmaterialien und Schichtdicken einsetzbar ist. Weiterhin kann das erfindungsgemäße Verfahren mehrfach angewendet werden, falls das Abtragsprofil im ersten Versuch nicht erreicht werden konnte. Dabei profitiert der Maschinendurchsatz erheblich von Fortschritten, die sich in den Verfahren zur Schichtabscheidung ergeben.

Bevorzugt erfolgt die Bearbeitung der Schicht über den gesamten Wafer, wobei das erfindungsgemäße Verfahren an die Anforderungen, die durch eine industrielle Massenfertigung, beispielsweise hinsichtlich des Durchsatzes, vorgegeben sind, angepaßt ist. Die Bearbeitungszeit des erfindungemäßen Verfahren liegen im Bereich zwischen 1 und 60 Minuten.

Gemäß einer bevorzugten Ausführungsform der Erfindung wird das erfindungsgemäße Verfahren zur Einstellung der Eigenfrequenzen von piezoelektrischen Schwingkreisen verwendet. Auf diese Weise erhält man ein Verfahren, das eine direkte Einflußnahme auf die Eigenfrequenz erlaubt. Dabei ist das Verfahren vor, während und nach Fertigstellung des Schwingerstacks anwendbar. Es ist jedoch bevorzugt, wenn das Verfahren an einem bereits im wesentlichen fertiggestellten Schwingkreis durchgeführt wird. Darüber hinaus besitzt das erfindungsgemäße Verfahren den Vorteil, daß ein Frequenzabgleich auf Waferebene durchgeführt werden und daß die Eigenfrequenzen von piezoelektrischen Schwingkreisen über einen großen Trimmbereich von bis zu 20% eingestellt werden können.

Gemäß einer im Vertragsstaat NL bevorzugten und in den übrigen Vertragsstaaten erfindungsgemäßen Ausführungsform der Erfindung ist die Ausdehnung des Ionenstrahls größer als 1 mm, bevorzugt größer als 5 mm. Weiterhin ist es in allen Vertragsstaaten bevorzugt, wenn die Ausdehnung des Ionenstrahls kleiner als 100 mm, bevorzugt kleiner als 50 mm ist.

Gemäß einer bevorzugten Ausführungsform der Erfindung wird als Ionenstrahl ein on-Ionenstrahl verwendet. Weiterhin ist es im Vertragsstaat NL bevorzugt und in den übrigen Vertragsstaaten erfindungsgemäß, wenn ein Ionenstrahl mit einer gaussförmigen Stromdichteverteilung verwendet wird. In diesem Fall wird die Halbwertsbreite des Ionenstrahls als Ausdehnung des Ionenstrahls verstanden. In allen Vertragsstaaten ist es insbesondere bevorzugt, wenn der Ionenstrahl in Spuren über die Schicht geführt wird und der Spurabstand kleiner als die Halbwertsbreite des Ionenstrahls ist.

Weiterhin ist es im Vertragsstaat NL insbesondere bevorzugt, wenn ein Ionenstrahl mit einer homogenen Stromdichteverteilung verwendet wird. Dabei ist es insbesondere bevorzugt, wenn der Ionenstrahl in Spuren über die Schicht geführt wird und der Spurabstand kleiner als die Ausdehnung des Ionenstrahls ist. In beiden Fällen können somit die Steuerdaten für den Ionenstrahl, beispielsweise für den Verschiebetisch und die Quellensteuerung, aus einer inversen Faltung des gewünschten Abtragsprofils mit dem sogenannten "Ätz-Footprint" des Ionenstrahls gewonnen werden. Weiterhin ist es in allen Vertragsstaaten insbesondere bevorzugt, wenn die lokale Ätzung der Schicht durch die Stromdichte des Ionenstrahls und/oder die Geschwindigkeit, mit welcher der Ionenstrahl über die Schicht geführt wird, gesteuert wird.

Gemäß einer weiteren bevorzugten Ausführungsform wird vor Schritt c) eine Maske, insbesondere eine Lackmaske, auf die Schicht aufgebracht, die nur die zu ätzenden Bereiche der Schicht offen läßt.

Wird das erfindungsgemäße Verfahren zur Einstellung von Eigenfrequenzen bei piezoelektrischen Schwingkreisen eingesetzt, so ist es insbesondere bevorzugt, wenn zur Bestimmung des Abtragsprofils der aufgebrachten Schicht eine elektrische Messung der Eigenfrequenz der piezoelektrischen Schwingkreise durchgeführt wird.

Die Erfindung wird nachfolgend anhand von Figuren der Zeichnung näher dargestellt. Es zeigen:
- Fig. 1: einen mit Hilfe des erfindungsgemäßen Verfahrens hergestellten piezoelektrischen Schwingkreis,
- Fig. 2 - 4: eine Ausführungsform des erfindungsgemäßen Verfahrens am Beispiel des Fig. 1 gezeigten, piezoelektrischen Schwingkreises,
- Fig. 5: ein typisches Abtragsprofil eines überwiegend rotationssymmetrischen Mitte-Rand-Fehlers in der Dicke einer Metallschicht,
- Fig. 6: ein gemessenes Abtragsprofil einer Ionenstrahlätzung, und
- Fig. 7 - 8: eine weitere Ausführungsform des erfindungsgemäßen Verfahrens.

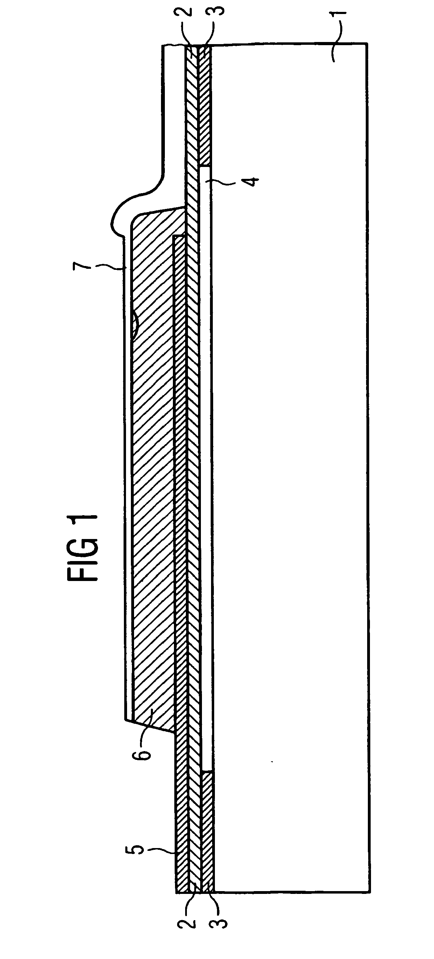

Fig. 1 zeigt einen mit Hilfe des erfindungsgemäßen Verfahrens hergestellten piezoelektrischen Schwingkreis. Auf einem Wafer 1 befindet sich eine Trägerschicht 2, die vorzugsweise Polysilizium ist und unter der sich im Bereich einer als Schwingkreis vorgesehenen Schichtstruktur ein Hohlraum 4 in einer Hilfsschicht 3 z. B. aus Oxid befindet. Der Hohlraum besitzt typisch die Abmessung von etwa 200 µm. Auf der Trägerschicht 2 befindet sich die Schichtstruktur des Schwingkreises aus einer für die Bodenelektrode vorgesehenen unteren Elektrodenschicht 5, einer Piezoschicht 6 und einer für die Deckelelektrode vorgesehenen oberen Elektrodenschicht 7. Die Elektrodenschichten 5, 7 sind vorzugsweise Metall, und die Piezoschicht 6 ist z. B. AlN, ZnO oder PZT-Keramik (PbZrTi). Diese Schichtstruktur besitzt insgesamt typisch die Dicke von etwa 5 µm. Anstatt des Hohlraums können auch andere akustisch isolierende Unterbauten, wie beispielsweise akustische Spiegel, verwendet werden.

Zur Einstellung einer der gewünschten Eigenfrequenz wurde die oberen Elektrodenschicht 7 mit einem lokal angepaßtem Dickenprofil erzeugt. Im vorliegenden Beispiel bedeutet dies, daß die oberen Elektrodenschicht 7 im Bereich des piezoelektrischen Schwingkreises direkt über der Piezoschicht 6 deutlich dünner ausgebildet als in den übrigen Bereichen. Dabei wurde das in Fig. 1 gezeigte Dickenprofil der oberen Elektrodenschicht 7 entsprechend einem erfindungsgemäßen Verfahren erzeugt.

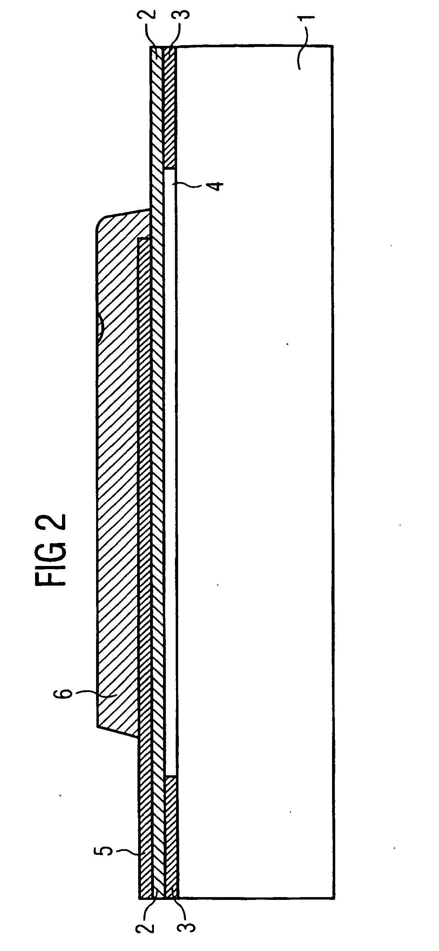

Die Figuren 2 bis 4 zeigen eine Ausführungsform des erfindungsgemäßen Verfahrens am Beispiel des in Fig. 1 gezeigten, piezoelektrischen Resonators. Der Ausgangspunkt ist dabei die in Fig. 2 gezeigte Struktur, die einem piezoelektrischen Schwingkreis ohne oberen Elektrodenschicht 7 entspricht. Die in Fig. 2 gezeigte Struktur wirkt somit als eine Art Substrat für die nachfolgende Abscheidung der oberen Elektrodenschicht 7.

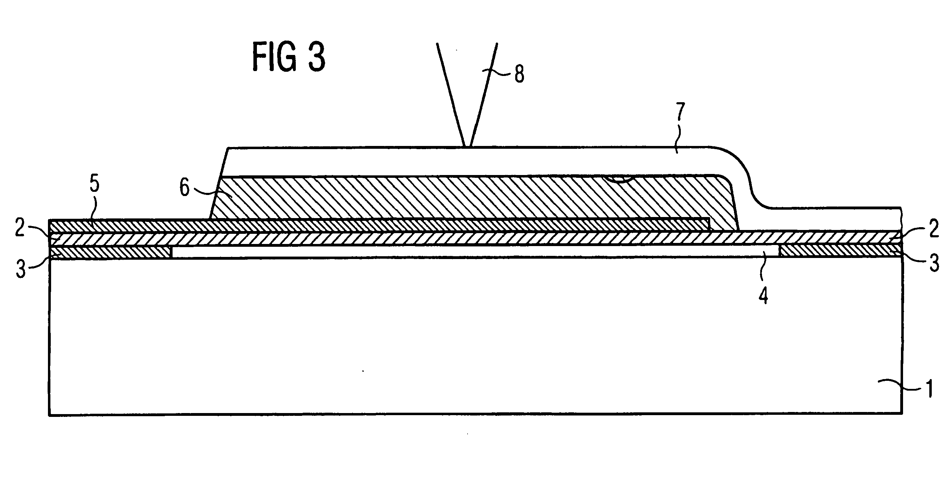

Anschließend wird durch ein Sputterverfahren ein relativ dicke Metallschicht, beispielsweise eine Wolfram-Schicht, erzeugt. Anstelle eines Sputterverfahrens kann auch ein CVD-Verfahren oder ein elektrochemisches Verfahren eingesetzt werden. Nach dem Aufbringen der Metallschicht wird das Abtragsprofil für das Metall bestimmt. Im vorliegenden Beispiel erfolgt diese Bestimmung am Ort des Schwingkreises durch eine Messung der Eigenfrequenz des Schwingkreises. Dazu wird ein Nadelkontakt 8 auf die Metallschicht geführt und die Impendanz des Schwingkreises in Abhängigkeit der Frequenz der elektrischen Anregung gemessen (Fig. 3). Aus der so gewonnenen Impedanzkurve kann die Eigenfrequenz bestimmt werden. Die gemessene Eigenfrequenz wird nun mit der gewünschten Eigenfrequenz für den piezoelektrischen Schwingkreis verglichen, wodurch der Teil der Schicht, der abgetragen werden muß, berechnet werden kann. Da dies bei unterschiedlichen Schwingkreisen auf dem Wafer 1 aufgrund der Dickenschwankungen der Schicht und/oder aufgrund von unterschiedlichen Funktionen der Schwingkreise unterschiedlich dicke Teile der Schicht sind, ergibt sich über den gesamten Wafer ein bestimmtes Abtragsprofil, das nachfolgend zur Steuerung des Ionenstrahlätzens verwendet wird.

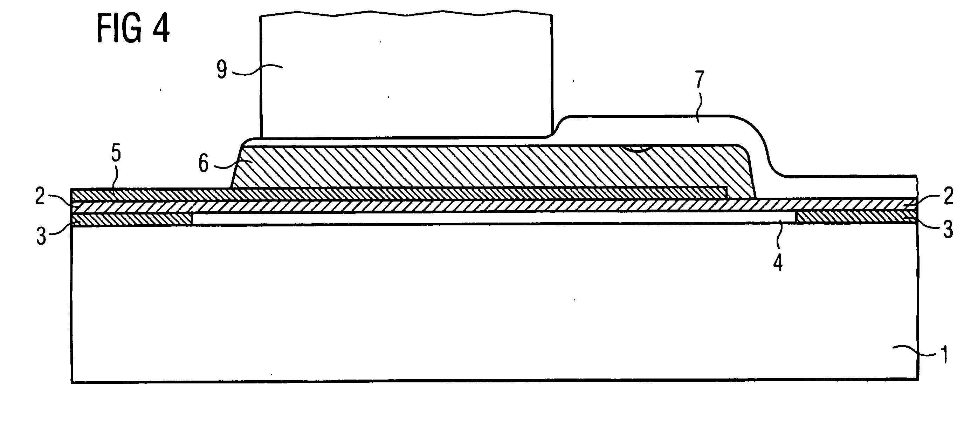

Anschließend wird ein Ionenstrahl 9 zumindest einmal über die Schicht geführt, so daß am Ort des Ionenstrahls eine lokale Ätzung der Metallschicht entsprechend dem Abtragsprofil erfolgt und eine Metallschicht 7 mit einem lokal an die gewünschte Eigenfrequenz des Schwingkreises angepaßten Schichtdickenprofil erzeugt wird (Fig. 4). Durch mechanisches Abrastern des Wafers mit einem gaussförmigen Ionenstrahl (der entsprechenden Durchmesser aufweist) kann ein lokal steuerbarer Abtrag realisiert werden. Wird der Wafer in Spuren abgescant, dann kann entweder der Strahlstrom oder die Scangeschwindigkeit entsprechend dem lokal benötigten Abtrag gesteuert werden. Das Abrastern erfolgt in beliebiger Folge aus Spuren in x- und y-Richtung (alternativ sind auch konzentrische Ringe oder Spiralen möglich), deren Spurabstand deutlich kleiner als die Halbwertsbreite des lonenstrahls ist.

Die Wahl des Strahldurchmessers erfolgt entsprechend des größten geforderten Abtragsgradienten; kleine Strahldurchmesser erlauben steilere Gradienten, ergeben jedoch global geringeren Volumenabtrag pro Zeiteinheit. Die Steuerdaten für den Verschiebetisch und die Quellensteuerung werden aus einer inversen Faltung des gewünschten Abtragsprofils mit dem sogenannten "Ätz-Footprint" des Ionenstrahls gewonnen.

Anstatt eines Ionenstrahl mit einer gaussförmigen Stromdichteverteilung kann im Vertragsstaat NL auch ein Ionenstrahl mit einer homogenen Stromdichteverteilung verwendet werden. In diesem Fall sollte der Spurabstand kleiner als die Ausdehnung des Ionenstrahls sein.

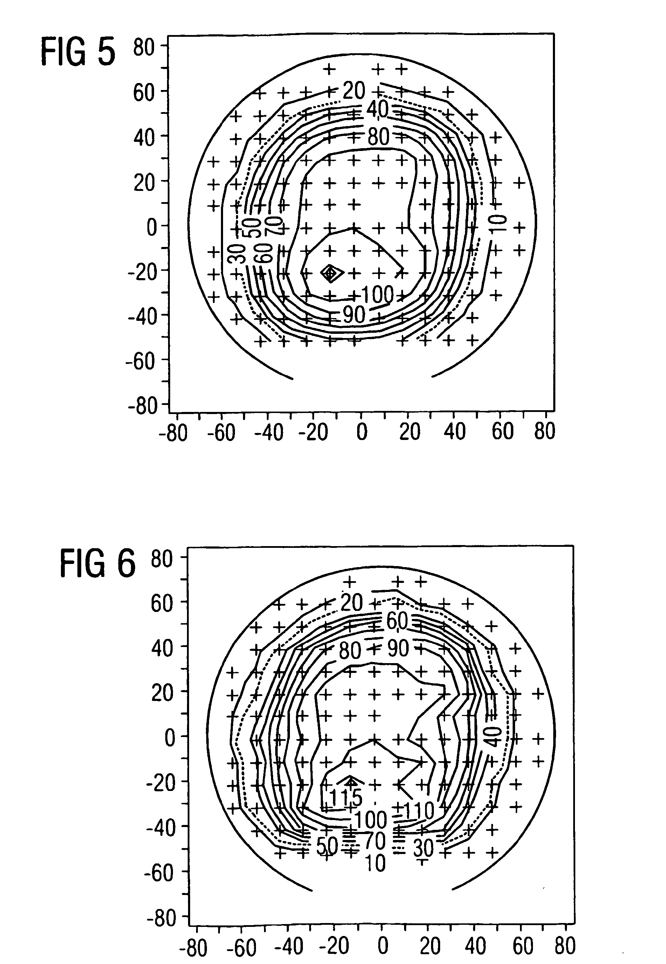

Fig. 5 zeigt ein typisches Abtragsprofil eines überwiegend rotationssymmetrischen Mitte-Rand-Fehlers in der Dicke einer Metallschicht, wie es aus einer elektrischen Frequenzmessung an ca. 150 Waferpositionen, entspricht 150 piezoelektrischen Schwingkreisen, berechnet werden kann. Fig. 6 zeigt das entsprechende, gemessene Abtragsprofil einer Ionenstrahlätzung mit einem gaussförmigen Ar-Ionenstrahl (Halbwertsdurchmesser zwischen 5 und 50 mm), das mit einer Geschwindigkeitsteuerung in der x-Richtung erzielt wurde. Der Spurabstand in y-Richtung betrug etwa 10% des Halbwertsdurchmessers. Der verbleibende Fehler lag im Bereich zwischen 1 und 20 nm. Das erfindungsgemäße Verfahren besitzt den Vorteil, daß ein Frequenzabgleich auf Waferebene durchgeführt werden kann und daß die Eigenfrequenzen von piezoelektrischen Schwingkreisen über einen großen Trimmbereich von bis zu 20% und einer Frequenzgenauigkeit von 0.25% eingestellt werden können.

Bei der bisher beschriebenen Ausführungsform des erfindungsgemäßen Verfahrens wurde eine Schicht mit einem lokal an die gewünschte Eigenfrequenz der Schwingkreise angepaßtem Schichtdickenprofil erzeugt. Die Anpassung des Schichtdickenprofils muß jedoch nicht notwendigerweise in Hinblick auf die Eigenfrequenz eines Schwingkreises erfolgen. Mit dem erfindungsgemäßen Verfahren kann beispielsweise auch eine Vielzahl von Widerständen und/oder Kondensatoren mit unterschiedlichen Impedanzwerten aber gleichen lateralen Abmessungen erzeugt werden. Das erfindungsgemäße Verfahren wird dann dazu genutzt ein an den jeweiligen Widerstand bzw. Kondensator lokal angepaßtes Schichtdickenprofil zu erzeugen. Weiterhin kann mit dem erfindungsgemäßen Verfahren eine Vielzahl von Membranen mit unterschiedlichen mechanischen Parametern aber gleichen lateralen Abmessungen erzeugt werden. Das erfindungsgemäße Verfahren wird dann dazu genutzt ein an die jeweilige Membran angepaßtes Schichtdickenprofil des Membranmaterials zu erzeugen.

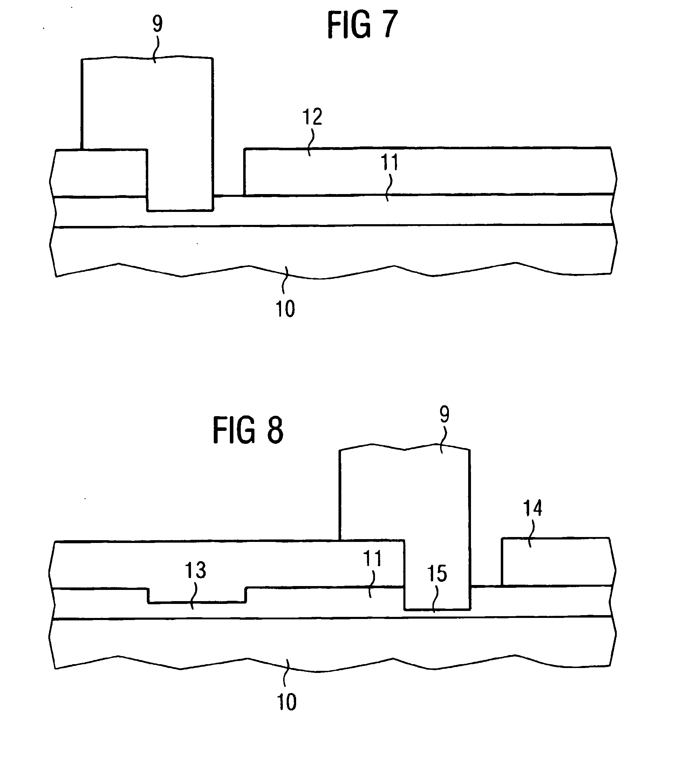

Die Figuren 7 - 8 zeigen eine weitere Ausführungsform des erfindungsgemäßen Verfahrens. Auf ein Substrat 10 wird ein relativ dicke Schicht 11 erzeugt. Anstelle eines Sputterverfahrens kann auch ein CVD-Verfahren oder ein elektrochemisches Verfahren eingesetzt werden. In Abhängigkeit der gewünschten Anwendung kann das Substrat 10 eine isolierende Schicht, beispielsweise eine Oxidschicht, und die Schicht 11 eine leitende Schicht, beispielsweise eine Metallschicht, sein. Eine derartige Wahl der Materialien wäre beispielsweise für die Erzeugung von Widerständen mit vorgegebenen, unterschiedlichen Widerstandswerten geeignet. Sollen hingegen Kondensatoren mit vorgegebenen, unterschiedlichen Impedanzwerten erzeugt werden, so würde als Substrat 10 eine leitende Schicht, beispielsweise eine Metallschicht, und als Schicht 11 eine isolierende Schicht, beispielsweise eine Oxidschicht, gewählt werden.

Nach dem Aufbringen der Schicht 11 und einer möglichen Strukturierung der Schicht 11 wird das Abtragsprofil für die Schicht 11 bestimmt. Für den Fall, daß Widerständen mit vorgegebenen, unterschiedlichen Widerstandswerten erzeugt werden sollen, kann das Abtragsprofil beispielsweise mit einer Widerstandsmessung bestimmt werden. Es können jedoch auch interferometrische Messungen eingesetzt werden.

Das vorliegende Beispiel geht davon aus, daß verteilt über den Wafer Widerstände mit zwei unterschiedlichen Widerstandswerten erzeugt werden sollen. Daher wird anschließend eine Lackschicht aufgebracht und entwickelt, so daß eine Lackmaske 12 entsteht, welche an den Stellen geöffnet ist, an denen die Widerstände 13 mit einem ersten Widerstandswert erzeugt werden sollen. Anschließend erfolgt eine Ionenstrahlätzung, die an den geöffneten Stellen der Lackmaske 12 eine Ätzung entsprechend dem vorgegebenen Abtragsprofil mit einem Ionenstrahl 9 durchführt. Alle übrigen Bereiche der Schicht 11 werden dabei durch die Lackmaske 12 geschützt (Fig. 7).

Ist die erste Ionenstrahlätzung abgeschlossen, wird die Lackmaske 12 entfernt und eine weitere Lackschicht aufgebracht und entwickelt, so daß eine weitere Lackmaske 14 entsteht, welche an den Stellen geöffnet ist, an denen die Widerstände 15 mit einem zweiten Widerstandswert erzeugt werden sollen. Anschließend erfolgt wiederum eine Ionenstrahlätzung, die an den geöffneten Stellen der Lackmaske 14 eine Ätzung entsprechend dem vorgegebenen Abtragsprofil durchführt. Alle übrigen Bereiche der Schicht 11 werden dabei durch die Lackmaske 14 geschützt (Fig. 8). Nach der Entfernung der Lackmaske 14 erhält man eine somit eine Schicht 11 mit einem an den jeweiligen Widerstand lokal angepaßtem Schichtdickenprofil.

## Patentansprüche (Patentansprüche für folgende(n) Vertragsstaat(en): DE, FR, GB, IT)

1. Verfahren zur Herstellung einer Schicht mit einem lokal angepaßten bzw. vorgegebenen Schichtdickenprofil mit den Schritten:
a) zumindest eine Schicht wird auf ein Substrat aufgebracht,
b) ein Abtragsprofil für die aufgebrachte Schicht wird durch Vermessung der aufgebrachten Schicht bestimmt, und
c) zumindest ein Ionenstrahl wird zumindest einmal über die Schicht geführt, so daß am Ort des Ionenstrahls eine lokale Ätzung der Schicht entsprechend dem Abtragsprofil erfolgt und eine Schicht mit einem lokal angepaßten bzw. vorgegebenen Schichtdickenprofil erzeugt wird, wobei die Ausdehnung des Ionenstrahls größer als 1 mm, bevorzugt größer als 5 mm ist und wobei ein Ionenstrahl mit einer gaussförmigen Stromdichteverteilung verwendet wird.

2. Verfahren nach Anspruch 1,
**dadurch gekennzeichnet, daß**
die Ausdehnung des Ionenstrahls kleiner als 100 mm, bevorzugt kleiner als 50 mm ist.

3. Verfahren nach einem der Ansprüche 1 oder 2,
**dadurch gekennzeichnet, daß**
als Ionenstrahl ein Argon-Ionenstrahl verwendet wird.

4. Verfahren nach einem der Ansprüche 1 bis 3,
**dadurch gekennzeichnet, daß**
der Ionenstrahl in Spuren über die Schicht geführt wird und der Spurabstand kleiner als die Halbwertsbreite des Ionenstrahls ist.

5. Verfahren nach einem der Ansprüche 1 bis 4,
**dadurch gekennzeichnet, daß**
die lokale Ätzung der Schicht durch die Stromdichte des Ionenstrahls und/oder die Geschwindigkeit, mit der Ionenstrahl über die Schicht geführt wird, gesteuert wird.

6. Verfahren nach einem der Ansprüche 1 bis 5,
**dadurch gekennzeichnet, daß**
vor Schritt c) eine Maske, insbesondere eine Lackmaske, auf die Schicht aufgebracht wird, die nur die zu ätzenden Bereiche der Schicht offen läßt.

7. Verfahren nach einem der Ansprüche 1 bis 6,
**dadurch gekennzeichnet, daß**
das Verfahren zur Einstellung der Eigenfrequenzen von piezoelektrischen Schwingkreisen verwendet wird.

8. Verfahren nach Anspruch 7,
**dadurch gekennzeichnet, daß**
zur Bestimmung des Abtragsprofils für die aufgebrachte Schicht eine elektrische Messung der Eigenfrequenzen der piezoelektrischen Schwingkreise durchgeführt wird.

9. Verfahren nach einem der Ansprüche 1 bis 7,
**dadurch gekennzeichnet, daß**
das Verfahren zur Einstellung der Impendanzen von Widerständen und/oder Kondensatoren verwendet wird.

10. Verfahren nach einem der Ansprüche 1 bis 7,
**dadurch gekennzeichnet, daß**
das Verfahren zur Erzeugung einer Vielzahl von Membranen mit unterschiedlichen mechanischen Parametern verwendet wird.

## Patentansprüche (Patentansprüche für folgende(n) Vertragsstaat(en): NL)

1. Verfahren zur Herstellung einer Schicht mit einem lokal angepaßten bzw. vorgegebenen Schichtdickenprofil mit den Schritten:
c) zumindest eine Schicht wird auf ein Substrat aufgebracht,
d) ein Abtragsprofil für die aufgebrachte Schicht wird durch Vermessung der aufgebrachten Schicht bestimmt, und
c) zumindest ein Ionenstrahl wird zumindest einmal über die Schicht geführt, so daß am Ort des Ionenstrahls eine lokale Ätzung der Schicht entsprechend dem Abtragsprofil erfolgt und eine Schicht mit einem lokal angepaßten bzw. vorgegebenen Schichtdickenprofil erzeugt wird.

2. Verfahren nach Anspruch 1,
**dadurch gekennzeichnet, daß**
die Ausdehnung des Ionenstrahls größer als 1 mm, bevorzugt größer als 5 mm ist.

3. Verfahren nach Anspruch 1 oder 2,
**dadurch gekennzeichnet, daß**
die Ausdehnung des Ionenstrahls kleiner als 100 mm, bevorzugt kleiner als 50 mm ist.

4. Verfahren nach einem der Ansprüche 1 bis 3,
**dadurch gekennzeichnet, daß**
als Ionenstrahl ein Argon-Ionenstrahl verwendet wird.

5. Verfahren nach einem der Ansprüche 1 bis 4,
**dadurch gekennzeichnet, daß**
ein Ionenstrahl mit einer gaussförmigen Stromdichteverteilung verwendet wird.

6. Verfahren nach Anspruch 5,
**dadurch gekennzeichnet, daß**
der Ionenstrahl in Spuren über die Schicht geführt wird und der Spurabstand kleiner als die Halbwertsbreite des Ionenstrahls ist.

7. Verfahren nach einem der Ansprüche 1 bis 4,
**dadurch gekennzeichnet, daß**
ein Ionenstrahl mit einer homogenen Stromdichteverteilung verwendet wird.

8. Verfahren nach Anspruch 7,
**dadurch gekennzeichnet, daß**
der Ionenstrahl in Spuren über die Schicht geführt wird und der Spurabstand kleiner als die Ausdehnung des Ionenstrahls ist.

9. Verfahren nach einem der Ansprüche 1 bis 8,
**dadurch gekennzeichnet, daß**
die lokale Ätzung der Schicht durch die Stromdichte des Ionenstrahls und/oder die Geschwindigkeit, mit der Ionenstrahl über die Schicht geführt wird, gesteuert wird.

10. Verfahren nach einem der Ansprüche 1 bis 9,
**dadurch gekennzeichnet, daß**
vor Schritt c) eine Maske, insbesondere eine Lackmaske, auf die Schicht aufgebracht wird, die nur die zu ätzenden Bereiche der Schicht offen läßt.

11. Verfahren nach einem der Ansprüche 1 bis 10,
**dadurch gekennzeichnet, daß**
das Verfahren zur Einstellung der Eigenfrequenzen von piezoelektrischen Schwingkreisen verwendet wird.

12. Verfahren nach Anspruch 11,
**dadurch gekennzeichnet, daß**
zur Bestimmung des Abtragsprofils für die aufgebrachte Schicht eine elektrische Messung der Eigenfrequenzen der piezoelektrischen Schwingkreise durchgeführt wird.

13. Verfahren nach einem der Ansprüche 1 bis 10,
**dadurch gekennzeichnet, daß**
das Verfahren zur Einstellung der Impendanzen von Widerständen und/oder Kondensatoren verwendet wird.

14. Verfahren nach einem der Ansprüche 1 bis 10,
**dadurch gekennzeichnet, daß**
das Verfahren zur Erzeugung einer Vielzahl von Membranen mit unterschiedlichen mechanischen Parametern verwendet wird.

## Claims (Claims for the following Contracting State(s): DE, FR, GB, IT)

1. Method for producing a layer with a locally adapted or predefined layer thickness profile having the following steps:
a) at least one layer is applied to a substrate,
b) a removal profile for the applied layer is determined by measuring the applied layer, and
c) at least one ion beam is guided over the layer at least once, so that, at the location of the ion beam, the layer is etched locally in accordance with the removal profile and a layer with a locally adapted or predefined layer thickness profile is produced, the extent of the ion beam being greater than 1 mm, preferably greater than 5 mm and an ion beam with a Gaussian current density distribution being used.

2. Method according to Claim 1,
**characterized in that**
the extent of the ion beam is less than 100 mm, preferably less than 50 mm.

3. Method according to one of Claims 1 and 2,
**characterized in that**
an argon ion beam is used as the ion beam.

4. Method according to one of Claims 1 to 3,
**characterized in that**
the ion beam is guided over the layer in tracks and the track spacing is less than the half-value width of the ion beam.

5. Method according to one of Claims 1 to 4,
**characterized in that**
the local etching of the layer is controlled by the current density of the ion beam and/or the speed with which the ion beam is guided over the layer.

6. Method according to one of Claims 1 to 5,
**characterized in that**
before step c), a mask, in particular a resist mask, is applied to the layer, which leaves open only the regions of the layer which are to be etched.

7. Method according to one of Claims 1 to 6,
**characterized in that**
the method is used for setting the natural frequencies of piezoelectric resonant circuits.

8. Method according to Claim 7,
**characterized in that**
an electrical measurement of the natural frequencies of the piezoelectric resonant circuits is carried out in order to determine the removal profile for the applied layer.

9. Method according to one of Claims 1 to 7,
**characterized in that**
the method is used for setting the impedances of resistors and/or capacitors.

10. Method according to one of Claims 1 to 7,
**characterized in that**
the method is used for producing a multiplicity of diaphragms with different mechanical parameters.

## Claims (Claims for the following Contracting State(s): NL)

1. Method for producing a layer with a locally adapted or predefined layer thickness profile having the following steps:
a) at least one layer is applied to a substrate,
b) a removal profile for the applied layer is determined by measuring the applied layer, and
c) at least one ion beam is guided over the layer at least once, so that, at the location of the ion beam, the layer is etched locally in accordance with the removal profile and a layer with a locally adapted or predefined layer thickness profile is produced.

2. Method according to Claim 1,
**characterized in that**
the extent of the ion beam is greater than 1 mm, preferably greater than 5 mm.

3. Method according to Claim 1 or 2,
**characterized in that**
the extent of the ion beam is less than 100 mm, preferably less than 50 mm.

4. Method according to one of Claims 1 to 3,
**characterized in that**
an argon ion beam is used as the ion beam.

5. Method according to one of Claims 1 to 4,
**characterized in that**
an ion beam with a Gaussian current density distribution is used.

6. Method according to Claim 5,
**characterized in that**
the ion beam is guided over the layer in tracks and the track spacing is less than the half-value width of the ion beam.

7. Method according to one of Claims 1 to 4,
**characterized in that**
an ion beam with a homogeneous current density distribution is used.

8. Method according to Claim 7,
**characterized in that**
the ion beam is guided over the layer in tracks and the track spacing is less than the extent of the ion beam.

9. Method according to one of Claims 1 to 8,
**characterized in that**
the local etching of the layer is controlled by the current density of the ion beam and/or the speed with which the ion beam is guided over the layer.

10. Method according to one of Claims 1 to 9,
**characterized in that**
before step c), a mask, in particular a resist mask, is applied to the layer, which leaves open only the regions of the layer which are to be etched.

11. Method according to one of Claims 1 to 10,
**characterized in that**
the method is used for setting the natural frequencies of piezoelectric resonant circuits.

12. Method according to Claim 11,
**characterized in that**
an electrical measurement of the natural frequencies of the piezoelectric resonant circuits is carried out in order to determine the removal profile for the applied layer.

13. Method according to one of Claims 1 to 10,
**characterized in that**
the method is used for setting the impedances of resistors and/or capacitors.

14. Method according to one of Claims 1 to 10,
**characterized in that**
the method is used for producing a multiplicity of diaphragms with different mechanical parameters.

## Revendications (Revendications pour l'(les) Etat(s) contractant(s) suivant(s): DE, FR, GB, IT)

1. Procédé de production d'une couche ayant un profil d'épaisseur de couche adapté localement ou prescrit comprenant les stades dans lesquels :
d) on dépose au moins une couche sur un substrat ;
e) on détermine un profil d'enlèvement de la couche déposée en mesurant la couche déposée ; et
f) on envoie au moins un faisceau d'ions au moins une fois sur la couche de manière à effectuer à l'emplacement du faisceau d'ions une attaque locale de la couche conformément au profil d'enlèvement et on produit une couche ayant un profil d'épaisseur de couche adapté localement ou prescrit, l'étendue du faisceau d'ions étant plus grande que 1 mm, de préférence plus grande que 5 mm, et on utilise un faisceau d'ions ayant une répartition gaussienne de la densité de courant.

2. Procédé suivant la revendication 1,
**caractérisé en ce que** l'étendue du faisceau d'ions est plus petite que 100 mm, de préférence plus petite que 50 mm.

3. Procédé suivant l'une des revendications 1 ou 2,
**caractérisé en ce que** l'on utilise comme faisceau d'ions un faisceau d'ions argon.

4. Procédé suivant l'une des revendications 1 à 3,
**caractérisé en ce que** l'on envoie le faisceau d'ions en traces sur la couche et la distance entre les traces est inférieure à la demi-largeur du faisceau d'ions.

5. Procédé suivant l'une des revendications 1 à 4,
**caractérisé en ce que** l'on règle l'attaque locale de la couche par la densité de courant du faisceau d'ions et/ou par la vitesse à laquelle on envoie le faisceau d'ions sur la couche.

6. Procédé suivant l'une des revendications 1 à 5,
**caractérisé en ce qu'**avant le stade c) on dépose sur la couche un masque, notamment un masque de vernis, qui ne laisse dégagées que les parties de la couche à attaquer.

7. Procédé suivant l'une des revendications 1 à 6,
**caractérisé en ce que** l'on utilise le procédé pour régler les fréquences propres de circuits oscillants piézoélectriques.

8. Procédé suivant la revendication 7,
**caractérisé en ce que**, pour la détermination du profil d'enlèvement de la couche déposée, on effectue une mesure électrique des fréquences propres du circuit oscillant piézoélectrique.

9. Procédé suivant l'une des revendications 1 à 7,
**caractérisé en ce que** l'on utilise le procédé pour régler les impédances de résistances et/ou de condensateurs.

10. Procédé suivant l'une des revendications 1 à 7,
**caractérisé en ce que** l'on utilise le procédé pour produire une pluralité de membranes ayant des paramètres mécaniques différents.

## Revendications (Revendications pour l'(les) Etat(s) contractant(s) suivant(s): NL)

1. Procédé de production d'une couche ayant un profil d'épaisseur de couche adapté localement ou prescrit comprenant les stades dans lesquels :
c) on dépose au moins une couche sur un substrat ;
d) on détermine un profil d'enlèvement de la couche déposée en mesurant la couche déposée ; et
c) on envoie au moins un faisceau d'ions au moins une fois sur la couche de manière à effectuer à l'emplacement du faisceau d'ions une attaque locale de la couche conformément au profil d'enlèvement et on produit une couche ayant un profil d'épaisseur de couche adapté localement ou prescrit.

2. Procédé suivant la revendication 1,
**caractérisé en ce que** l'étendue du faisceau d'ions est plus grande que 1 mm, de préférence plus grande que 5 mm.

3. Procédé suivant l'une des revendications 1 ou 2,
**caractérisé en ce que** l'étendue du faisceau d'ions est plus grande que 100 mm, de préférence plus grande que 50 mm.

4. Procédé suivant l'une des revendications 1 à 3,
**caractérisé en ce que** l'on utilise comme faisceau d'ions un faisceau d'ions argon.

5. Procédé suivant l'une des revendications 1 à 4,
**caractérisé en ce que** l'on envoie faisceau d'ions ayant une répartition gaussienne de la densité de courant.

6. Procédé suivant la revendication 5,
**caractérisé** l'on envoie le faisceau d'ions en traces sur la couche et la distance entre les traces est inférieure à la demi-largeur du faisceau d'ions.

7. Procédé suivant l'une des revendications 1 à 4,
**caractérisé en ce que** l'on utilise un faisceau d'ions ayant une répartition homogène de la densité de courant.

8. Procédé suivant la revendication 7,
**caractérisé en ce que** l'on envoie le faisceau d'ions en traces sur la couche et la distance entre les traces est plus petite que l'étendue du faisceau d'ions.

9. Procédé suivant l'une des revendications 1 à 8,
**caractérisé en ce que** l'on règle l'attaque locale de la couche par la densité de courant du faisceau d'ions et/ou par la vitesse à laquelle on envoie le faisceau d'ions sur la couche.

10. Procédé suivant l'une des revendications 1 à 9,
**caractérisé en ce qu'**avant le stade c) on dépose sur la couche un masque, notamment un masque de vernis, qui ne laisse dégagées que les parties de la couche à attaquer.

11. Procédé suivant l'une des revendications 1 à 6,
**caractérisé en ce que** l'on utilise le procédé pour régler les fréquences propres de circuits oscillants piézoélectriques.

12. Procédé suivant la revendication 11,
**caractérisé en ce que**, pour la détermination du profil d'enlèvement de la couche déposée, on effectue une mesure électrique des fréquences propres du circuit oscillant piézoélectrique.

13. Procédé suivant l'une des revendications 1 à 10,
**caractérisé en ce que** l'on utilise le procédé pour régler les impédances de résistances et/ou de condensateurs.

14. Procédé suivant l'une des revendications 1 à 10,
**caractérisé en ce que** l'on utilise le procédé pour produire une pluralité de membranes ayant des paramètres mécaniques différents.
